# EUROPEAN PATENT APPLICATION

(11) **EP 2 287 625 A1**
(43) Date of publication of application: **23.02.2011**
(21) Application number: 09167841.7
(22) Date of filing: 13.08.2009
(51) Int. Cl.: G01R 31/34, H02K 11/00, G01R 31/08, G01R 31/12

(54) **Device and method for detecting defects within the insulation of an insulated conductor**

(71) Applicant: Alstom Technology Ltd, 5400 Baden (CH)
(72) Inventor: Behrmann, Glenn, 5400 Baden (CH)

(57) **Abstract**

A device (1) for detecting and precisely locating defects (25) within the insulation of an insulated conductor (20) comprises an antenna (2), arranged to couple the high frequency signals (27) produced by the partial discharge pulses (26) generated by defects (25) within the insulating layer of the insulated conductor (20). The antenna (2) is connected to a connector (3) to be connected to a measurement device (4). The antenna (2) is a compact antenna having dimensions similar to or smaller than those of the cross section of the stator bar to be tested and is shaped to detect signals having a frequency less then 800 MHz. The present invention also refers to a method for detecting defects (25) within the insulation of an insulated conductor (20), such as for example stator bars (Roebel bars) of rotating electrical machines such as a generator or a motor or other electrical machines, during, for example, testing or manufacturing quality control operations.

## Description

### TECHNICAL FIELD

The present invention relates to a device and a method for detecting defects within the insulation of an insulated conductor.

In particular the present invention refers to a device and a method that may be used during manufacturing and quality test operations of stator bars (Roebel bars) of rotating electrical machines such as a generator or a motor.

### BACKGROUND OF THE INVENTION

Stator bars (Roebel bars) are known to comprise a bare bar built up of a plurality of individual, interwoven copper conductor strands.

Insulating layers are wrapped around each individual strand and around the bare bar in its entirety (this latter being the main insulating layer), and a further protective conductive/semi-conductive corona protection layer is applied over this main insulation layer.

In addition, this structure may be impregnated with a resin under vacuum and/or pressure.

Nevertheless, at the end of the manufacturing process, the insulation layers may contain certain defects that during operation cause partial discharges.

Defects are voids or delaminations or other such inhomogeneities in the insulation layers filled with gas, e.g. air or nitrogen or other by-products produced during the manufacturing process.

Partial discharges are the local discharges or breakdown within the insulation layers, with "partial" meaning that they are confined to only a part of the insulation layers or material (i.e. not being a total breakdown or flashover).

Partial discharges occur in the form of current pulses (partial discharge pulses) mainly confined within the defect and whose risetimes are very short (typically <1 nanosecond) depending on complex factors such as the pressure and composition of the gas within the defects in which they take place and which cannot be changed.

The partial discharge pulses generate radio frequency signals containing components which extend up to several hundred Megahertz (VHF, UHF).

The radio frequency signals propagate away from the defects during which they undergo severe reflection, dispersion and damping effects via a plurality of mechanisms and paths which cannot be changed, such that the higher the frequency of the signals, the stronger is the degradation due to these damping and dispersive effects.

Partial discharges can both indicate and cause degradation of the insulation by producing changes in the insulating qualities of adjacent materials or surfaces, often leading to further partial discharge activity, aging effects, and overall deterioration of the insulating layers, with the result that breakdown may occur.

Thus partial discharges are to be avoided and it is advantageous to detect them in order to mitigate their effects.

EP408813 discloses a device and a method for detecting partial discharges and thus defects within stator bar insulations during operation of an electric machine.

The device comprises a sensor made of a straight conductive trace on a printed circuit board which is placed immediately adjacent to the stator bar and during operation is able to detect the signals generated by the partial discharge pulses.

As the frequency content of the signals is high (hundreds of MHz), they undergo severe dispersion and damping effects as they propagate through the insulating layers, such that the higher the frequency, the stronger these damping and dispersive effects.

Thus, in order to detect signals generated by pulses emitted from defects far away from the location of the device, the sensors of EP408813 are made of long straight conductors (the longer the straight conductor the lower the detected frequency and the lower the detected frequency the longer the distance from the device of defects that can be detected).

Nevertheless, even if this device and method let the presence of a defect be detected, they do not allow the precise position of the defect to be determined (i.e. only the presence of a defect is detected, but the position of the defect is not precisely located).

EP1418437 discloses a method and a sensor that can be used during the manufacturing process or quality test operations to detect defects of the insulating layer of a stator bar.

According to EP1418437 in order to precisely locate the defects within the insulating layers, a high voltage is applied to the stator bar such that defects present within the insulating layers produce partial discharge pulses and thus radio frequency signals (having 3 GHz frequency) which may be detected by the device.

This method allows the defects to be very precisely located, because the very high frequency signals (3 GHz) are very strongly damped while propagating through the insulating layers, therefore partial discharges are only detectable very close to the defects that generate them.

JP2008304357 discloses a partial discharge measuring device utilising a patch antenna for detecting high frequency signals (1-2 GHz); thus the device disclosed in this document also is only able to detect partial discharges very close to the antenna location within the machine.

JP 08122388 discloses a partial discharge measuring device which detects radio frequency signals emitted by the partial discharges using an existing directional antenna. Since directional antennas always have a directivity that is not perfect, it is not possible to determine the exact location of the defect.

In addition, most of the signal strength generated by partial discharge pulses is found at much lower frequency components (hundreds of Megahertz) than those detected in the cited documents. This causes the risk that with the known devices a defect is not detected.

### SUMMARY OF THE INVENTION

The technical aim of the present invention is therefore to provide a device and a method by which the said problems of the known art are eliminated.

Within the scope of this technical aim, an object of the invention is to provide a device and a method that allow defects to be precisely located during manufacturing and/or quality test operations, by means of detecting the signals propagating away from defects present in the insulating layers.

A further object of the invention is to provide a device and method that allow defects generating partial discharges emitting signals having a frequency of some hundreds of MHz (less then 800 MHz and preferably around 400-600 MHz) to be detected.

The technical aim, together with these and further objects, are attained according to the invention by providing a device and a method in accordance with the accompanying claims.

### BRIEF DESCRIPTION OF THE DRAWINGS

Further characteristics and advantages of the invention will be more apparent from the description of preferred but non-exclusive embodiments of the device and method according to the invention, illustrated by way of non-limiting examples in the accompanying drawings, in which:
Figure 1 is a schematic view of a device of the invention during testing of a stator bar that has two defects;
Figures 2 and 3 are two schematic views of the device of the invention in first embodiments;
Figures 4 and 5 are two schematic views of the device of the invention in second embodiments;
Figures 6, 7, 8, 9 are schematic views of different antennas of the device according to the invention; and
Figure 10 is a sketch showing the dimensions of an antenna compared to those of a stator bar.

### DETAILED DESCRIPTION OF THE INVENTION

With reference to the figures, these show a device for detecting defects of an insulated conductor generally indicated by the reference 1.

In the simplest embodiment, the device 1 comprises an antenna 2 arranged to couple the signals (being radio frequency signals) produced by the pulses generated by a defect within the insulating layers of the insulated conductor.

The antenna 2 is connected to a connector 3 that connects the antenna 2 to a measurement device 4.

In particular the antenna 2 is a compact antenna, i.e. it has overall dimension smaller than the dimensions of the insulated conductor (such as a stator bar or Roebel bar) to be tested, and it is shaped to detect signals having a frequency of less then 800 MHz and preferably 400-600 MHz.

In particular the antenna 2 has overall dimension similar to (i.e. substantially the same) or smaller than the cross section 30 of the insulated conductor to be tested.

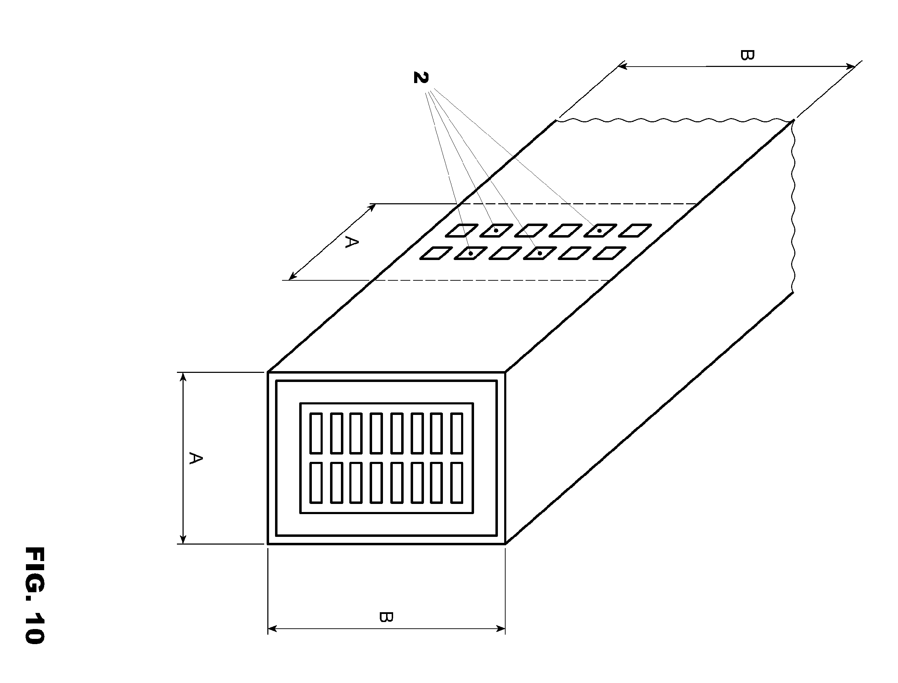

For example (figure 10), the overall dimension of the antenna is contained or bounded within a rectangular or square shape having dimensions similar to or less than the cross section of the insulated conductor.

In this respect, figure 10 shows the cross section of the stator bar being a rectangle having sides A and B, and on the side wall of the stator bar there is depicted a rectangle having sides A and B, this rectangle encloses or contains the antenna 2 (being one single antenna or comprising a plurality of antennas).

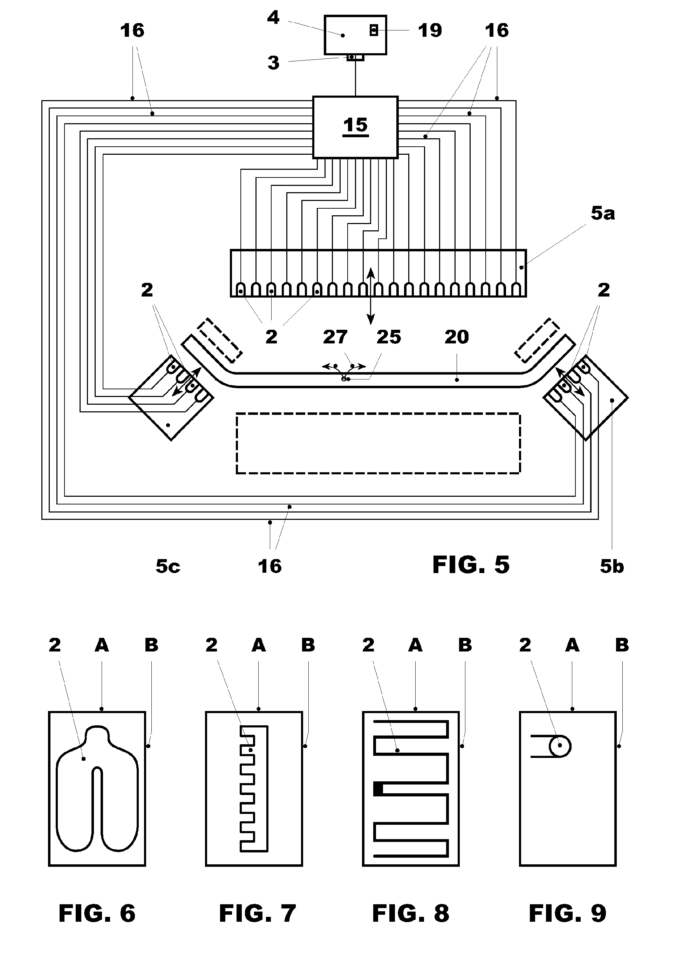

In case the antenna is in the form of a dipole antenna (figure 8) of a certain dimension (i.e. a wire), the electric conductors of this antenna may be bent one or more times in order to fit within the rectangular or square shape.

In case the antenna takes a different form, such as a patch antenna with one or more lobes or slots (figures 6 and 7), it is also contained or bounded within the square or rectangular shape.

Naturally other different embodiments of the antenna are also possible, such as a coil or solenoid (figure 9) which is contained within the rectangular or square shape (in particular the cross section of the coil is contained within the rectangular or square shape).

During operation this antenna is used in the near field, i.e. it is juxtaposed to the insulated conductor such that
D<<λ
wherein D is the distance between the antenna and the insulated conductor to be tested, and λ is the wavelength of the signals to be detected (typically these signals extend to frequencies of hundreds MHz).

One preferred embodiment of the antenna 2 is a patch antenna, i.e. it comprises one or more printed circuit boards imprinted with conductive traces.

The device 1 also comprises an enclosure 5 made of a conductive or semi-conductive material (for example it may be a metal enclosure) which houses the antenna 2.

The enclosure 5 is provided with an aperture 7 facing the antenna 2 such that the signals generated by the pulses directly illuminate the antenna 2.

Moreover, the antenna 2 is mounted in the enclosure 5 in such a way that it exhibits its highest sensitivity in the direction of the aperture 7, and the enclosure 5 is designed to enhance this directional sensitivity.

Further, the enclosure 5 provides a shielding against extraneous background radio frequency interference from every other direction so as to further enhance the sensitivity of the antenna and its signal-to-noise performance.

Preferably the aperture 7 is fitted with a gasket 8 arranged to make contact with the exterior surface of the insulated conductor as it undergoes test operations. Typically the outer layer of the insulated conductor is at ground potential and may be coated with a conductive or semi-conductive material in order to inhibit the formation of surface discharges (corona) when in operation, that is to say when high voltage is applied to the conductors.

Thus the purpose of the gasket 8 is to establish contact between the metallic enclosure 5 and the outer surface of the insulated conductor in order to provide further isolation of the antenna 2 from external electromagnetic signals and interference.

The gasket 8 is made of conductive or semi-conductive material; for example it is made of a metal powder loaded elastomer or a continuous metallic (conducting) coil or conductive plastic foam.

The device 1 also comprises an amplifier 10 and/or a filter 11 between each antenna 2 and the connector 3.

The amplifier 10 and the filter 11 are housed within the enclosure 5, so that they are protected against extraneous background radio frequency interference.

In different embodiments, the device of the invention may comprise a plurality of side-by-side antennas 2, each arranged to test a portion of the insulated conductor greater than the single antenna 2.

In this case the device may have a number of antennas 2, such that when they are juxtaposed to the insulated conductor they cover the entire length of the same conductor. This embodiment allows very rapid tests to be carried out as one single measurement allows the entire length of the insulated conductor to be surveyed and tested.

Alternatively, the device may have a number of antennas 2 such that when they are juxtaposed to the insulated conductor they cover only a part of the same insulated conductor; in this case more than one measure is necessary and/or the device must move along the length of the insulated conductor in order to sweep it in its entirety.

In these embodiments (with side-by-side antennas) the device is preferably provided with a multiplexer 15 to which each antenna 2 is connected via an individual transmission line 16.

The multiplexer 15 is connected to the connector 3 that is connected or is connectable to the measuring device 4.

The measuring device 4 may be part of the device 1 or may be a separate instrument.

If the measuring device 4 is a part of the device 1 it comprises a control unit 19 arranged to compare the signals from each antenna 2 to locate the defect (i.e. the partial discharge source).

In case the measurement device is a separate instrument, it may be a spectrum analyzer, an oscilloscope, a device which detects and displays signals generated by the partial discharge pulses with reference to phase of the applied power frequency test voltage waveform (e.g. sinewave of 50 or 60 Hz), or a combination of such devices. In this case the connector 3 is a coaxial cable (i.e. a shielded cable), connecting the antennas 2 to the measuring device 4.

In further embodiments the device 1 comprises two parts (or even more than two parts) each having at least one of the antennas 2.

These parts are arranged to test different sides of the insulated electric conductor and preferably opposite sides of the insulated conductor.

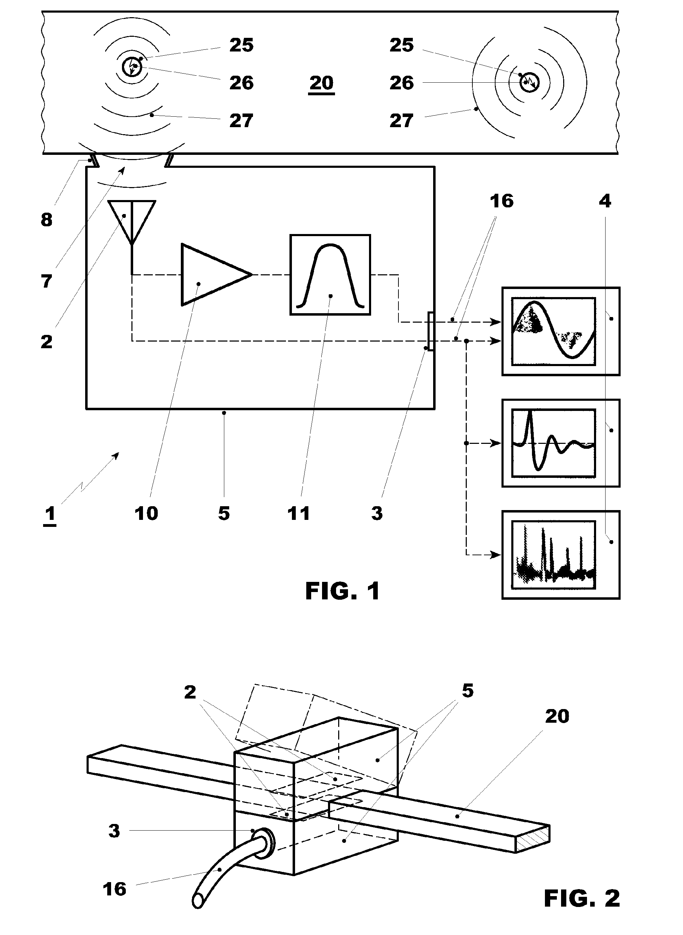

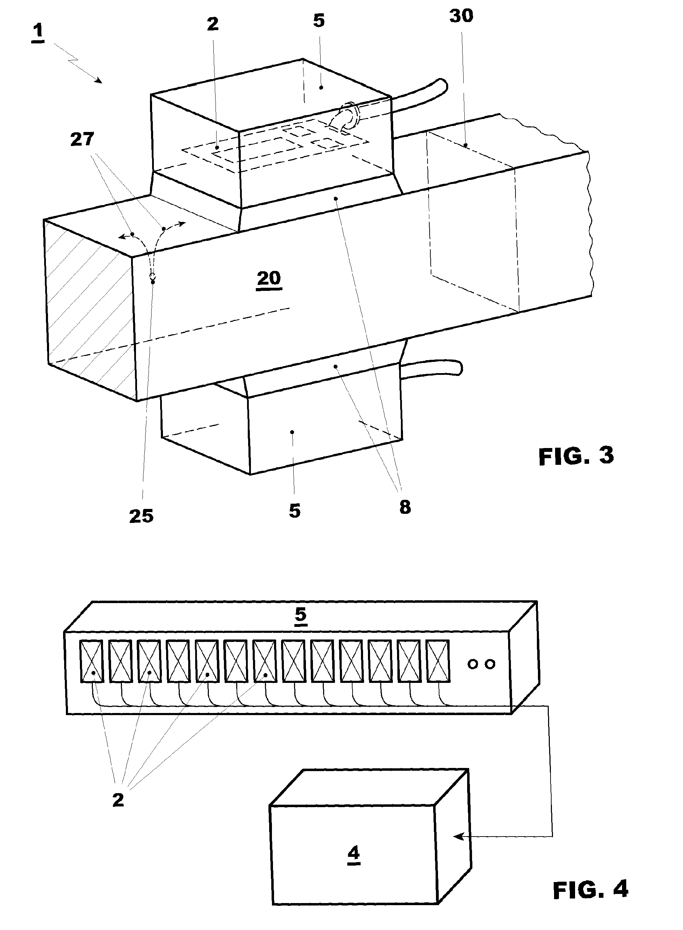

Figures 2 and 3 show devices in a first embodiment of the invention.

In particular, the device of figure 3 has two parts arranged to test opposite sides of the insulated conductor.

Each part is provided (in the enclosed figures) with an enclosure 5 containing an antenna 2 facing the aperture 7.

From the perimeter of the aperture 7 the gasket 8 extends arranged to slide along the surface of the insulated conductor.

In order to improve sliding of the each part of the device 1 along the insulated conductor, each enclosure 5 may be provided with rollers or other mechanisms to allow free movement of the enclosure over and along the length of the insulated conductor such that the distance between the insulation surface and the enclosure containing the device remains relatively constant, and also assuring that the conductive gasket 8 maintains good electrical contact with the stator bar outer surface in order to provide further isolation of the antenna 2 from external electromagnetic signals and interference.

The operation of the device in this embodiment of the invention is apparent from that described and illustrated and is substantially the following.

At the end of the manufacturing process of an insulated conductor (such as a stator bar or Roebel bar), an ac voltage (for example having 20 000 V tension and 50 or 60 Hz frequency) is applied to it for the purpose of testing the quality of the insulation layers.

Then the device 1 is juxtaposed to the stator bar and is made to slide along its whole length.

In case the insulating layers of the stator bar have no defect, the antennas 2 do not detect any signal (apart from some background noise).

In case the insulating layers of the stator bar have a defect 25, partial discharge pulses 26 are generated within the defect 25 that generate radio frequency signals 27 that propagate away from the defect 25 and undergo attenuation and dispersive effects as they propagate within and along the stator bar.

When the device 1 (that slides along the stator bar) approaches the defects 25, the antenna 2 couples capacitively or inductively or a combination thereof the radio frequency signals 27 generated by the pulses 26.

As the radio frequency signals 27 contain high frequency components, which undergo rapid attenuation and dispersion as they propagate along the stator bar, the magnitude of the detected radio frequency signals 27 increases when the antenna approaches the defect 25 and decreases when the antenna moves away from the defect 25.

As the antenna 2 is a compact antenna, i.e. it has very small dimensions (compared to the dimensions of the stator bar to be tested) the location of the defect can be very precisely ascertained when the magnitude of the detected signals generated by the partial discharge pulses shows a peak in magnitude, as for example measured by certain measuring devices 4 such as a spectrum analyzer, an oscilloscope, or a device for displaying partial discharge with reference to the phase of the applied power frequency test voltage waveform, or a combination of such devices.

In case the device has more than one single antenna (for example these antennas are side-by-side perpendicular to the sliding direction, such as for example those shown in figure 10), while the device 1 slides on the stator bar, the control unit 19 identifies the particular antenna 2 that detects the highest signal 27 and, thus, precisely indicates the location of the defect 25.

Figures 4 and 5 shows further embodiments of the invention.

In particular, the device of figure 5 has a first part with an enclosure 5a arranged to test the straight part (or slot part) of a Roebel bar and two further parts having enclosures 5b and 5c arranged to test the bent parts of the Roebel bar. Figure 5 also shows in dashed line further parts that could be provided to test the Roebel bar at both opposite sides.

Advantageously the enclosure 5a is at least as long as the straight part of the stator bar to be tested and the enclosures 5b and 5c are at least as long as the bent parts of the stator bar; this lets the stator bar be tested with one single measure.

In case the straight part of the stator bar is longer than the enclosure 5a, or the bent parts of the stator bar are longer than the enclosures 5b and 5c, more than one measure is necessary; i.e. a first test is carried out and then the stator bar and/or the device are moved to test also the rest of the bar.

Each enclosure 5a, 5b, 5c houses a plurality of antennas 2 each connected to an amplifier and a filter; in case the antennas take the form of patch antennas, each antenna and/or filter and/or amplifier may be implemented in groups of one or more printed circuit boards.

Each antenna (through the amplifier and filter) is connected to the multiplexer and the measuring device.

The operation of the device in this embodiment of the invention is apparent from that described and illustrated and is substantially the following.

At the end of the manufacturing process the insulated conductor (stator bar or Roebel bar) is supplied with an ac voltage having 20 000 V tension and 50 Hz frequency for the purpose of testing the quality of the insulation layers.

Thus the enclosures 5a, 5b, 5c are juxtaposed to the stator bar (with the gaskets 8 in contact with the stator bar) .

In case a defect exists, partial discharge pulses 26 are generated within the defect 25; these partial discharge pulses 26 generate radio frequency signals 27 which then propagate away from the defect 25 and undergo attenuating and dispersive effects as they propagate away from the defect 25.

The antennas 2 far away from the defect 25 do not detect any signal (because of the damping effects); the antennas 2 closer to the defect 25 detect a signal such that the greater the signal, the closer the defect to a certain antenna.

The control unit 19 identifies the particular antenna 2 which detects the signal of the highest magnitude and thus precisely indicates the location of the defect 25.

The present invention also relates to a method for detecting defects within the insulation layers of an insulated conductor.

The method consists in applying an ac voltage to an insulated conductor such that defects in the insulation layers generate pulses 26 within the defects and the pulses 26 generate radio frequency signals 27 propagating away from the defects 25, thus detecting, through at least an antenna 2, the radio frequency signals 27 having a frequency less then 800 MHz and preferably between 400-600 MHz generated by the pulses 26, and then transmitting the detected signals to a connector 3 for transmitting them to a measurement device 4, wherein the antenna 2 is a compact antenna.

The antenna operates in the near field.

Advantageously, a plurality of antennas is directly juxtaposed to the whole surface of the insulated conductor to be tested.

In particular the high frequency signals 27 generated by the pulses 26 are detected through a plurality of side-by-side antennas 2 and then the signals which they have detected are compared with each other to precisely locate the defect 25.

In a first embodiment of the method a plurality of antennas 2 are simultaneously juxtaposes to the insulated conductor to be tested, such that they cover a large portion of or the entire length of the same insulated conductor. In case a large portion of the length of the insulated conductor is covered by the side-by-side antennas (i.e. not the whole of its length), the insulated bar and/or the device are opportunely moved and the measure is repeated, such that the whole of the surface is tested.

In a different embodiment one or more antennas are juxtaposed to the insulated conductor to be tested and are moved along the surface of the insulated conductor to test all the length of the same insulated conductor.

Advantageously the high frequency signals generated by the pulses are detected at different sides (preferably opposite sides) of the insulated conductors.

Naturally the features described may be independently provided from one another.

The device and method conceived in this manner are susceptible to numerous modifications and variants, all falling within the scope of the inventive concept; moreover all details can be replaced by technically equivalent elements.

In practice the materials used and the dimensions can be chosen at will according to requirements and to the state of the art.

### REFERENCE NUMBERS

- 1: device
- 2: antenna
- 3: connector
- 4: measurement device
- 5,: 5a, 5b, 5c enclosure
- 7: aperture
- 8: gasket
- 10: amplifier
- 11: filter
- 15: multiplexer
- 16: individual transmission line, coaxial cable
- 19: control unit
- 20: insulated conductor or stator bar (Roebel bar)
- 25: defect
- 26: partial discharge pulses
- 27: radio frequency signals
- 30: cross section of the insulated conductor
- A,: B sides of the cross section

## Claims

1. Device (1) for detecting defects (25) of an insulated conductor (20) comprising an antenna (2), arranged to couple the signals (27) produced by pulses (26) generated by the defects (25) of the insulating layers of the insulated conductor (20), said antenna (20) being connected to a connector (3) for connecting it to a measurement device (4), **characterised in that** said antenna (2) is a compact antenna that is shaped to detect signals having a frequency of less then 800 MHz.

2. Device (1) as claimed in claim 1, **characterised in that** the antenna is shaped to detect signals having a frequency between 400-600 MHz.

3. Device (1) as claimed in claim 1, **characterised in that** said compact antenna has dimensions similar to or smaller than the cross section (30) of the insulated conductor to be tested.

4. Device (1) as claimed in claim 1, **characterised by** comprising an enclosure (5) made of a conductive or semi-conductive material housing said antenna (2) and provided with at least an aperture (7) facing said antenna (2).

5. Device (1) as claimed in claim 4, **characterised in that** said aperture (7) is provided with a gasket (8) arranged to make contact with the outer surface of the insulated conductor (20) to be tested during operation, said gasket (8) being made of conductive or semi-conductive material.

6. Device (1) as claimed in claim 1, **characterised by** comprising an amplifier (10) and/or a filter (11) between each antenna (2) and said connector (3), said amplifier (10) and/or filter (11) being housed within said enclosure (5).

7. Device (1) as claimed in claim 1, **characterised by** comprising a plurality of antennas (2) arranged side-by-side to test at least a portion of an insulated conductor (20) greater than a single antenna (2).

8. Device (1) as claimed in claim 7, **characterised by** comprising a multiplexer (15) to which each antenna (2) is connected via an individual transmission line (16), said multiplexer (15) being connected to said connector (3).

9. Device (1) as claimed in claim 7 or 8, **characterised by** comprising at least a measuring device (4) connected to said connector (3), said measuring device (4) comprising a control unit (19) arranged to compare the signals from each antenna (2) to locate the defect.

10. Device (1) as claimed in claim 1, **characterised by** comprising at least two parts each having at least an antenna (2), said parts being arranged to test different sides of the insulated electric conductor.

11. Method for detecting defects (25) of an insulated conductor (20) consisting in applying an ac voltage to the insulated conductor (20) such that defects (25) in the insulating layers generate pulses (26) that generate radio frequency signals (27) propagating away from the defects (25), thus detecting through at least one antenna (2) the radio frequency signals (27) and transmitting the detected signals to a connector (3) for transmitting them to a measurement device (4), **characterised in that** said antenna (4) is a compact antenna, and **in that** signals of a frequency of less then 800 MHz are detected.

12. Method according to claim 11, **characterised by** detecting radio frequency signals between 400-600 MHz.

13. Method according to claim 11, **characterised by** detecting the radio frequency signals (27) through a plurality of side-by-side antennas (2) and then comparing the signals from each antenna (2) to locate the defect (25).

14. Method according to claim 13, **characterised in that** said side-by-side antennas (2) cover a portion or all the length of the same insulated conductor (20).

15. Method according to claim 11, **characterised by** moving said at least an antenna (2) along the surface of the insulated conductor (20) to test all the length of the same insulated conductor (20).

16. Method according to claim 11, **characterised by** detecting the radio frequency signals (27) at different sides, preferably opposite sides, of the insulated conductor (20).
